# EUROPEAN PATENT APPLICATION

(11) **EP 1 046 922 A1**
(43) Date of publication of application: **25.10.2000**
(21) Application number: 00302347.0
(22) Date of filing: 22.03.2000
(51) Int. Cl.: G01R 31/3183, G06F 11/22, G06F 17/50

(54) **A method for checking designs with a verification tool**

(30) Priority: 29.03.1999 US 280169
(71) Applicant: LUCENT TECHNOLOGIES INC., Murray Hill, New Jersey 07974-0636 (US)
(72) Inventor: Hardin, Ronald H., Pataskala, OH 43062 (US); Kurshan, Robert Paul, New York, NY 10014 (US)
(74) Representative: Watts, Christopher Malcolm Kelway, Dr.

(57) **Abstract**

A system's ability to traverse a given sequence of states is checked by employing a verification tool to develop sets of input test vectors, where each set of input test vectors causes the system to move from one state in the given sequence of states to the next state in the given sequence of states. Each set of input test vectors is obtained by formulating the hypothesis that the system could not reach the desired state. Applying the hypothesis to the verification tools allows the tools to disprove the hypothesis by providing, as a means of disproving the hypothesis, the desires set of input test vector.

## Description

### Background of the Invention

This relates to testing of system designs, such as simulation testing of integrated circuit designs.

When designing an integrated circuit, it is common practice to test the circuit's operation prior to its actual manufacture. Conventionally, this is done with simulation software that applies signals, normally referred to as test vectors, to the signal points of the circuit that correspond to the manufactured circuit's input leads. The behavior of the circuit can be viewed by observing the signals at various points of the system, but often, the points of the system that are observed are the circuit points that correspond to the output leads of the manufactured circuit.

Normally, the circuit design is verified by specifying various sequences of states that the circuit is asked to traverse, and determining whether the design yields a circuit that does traverse the various specified sequences of states. To make the circuit move to state A, and then to state B, and then to state C, a sequence of input vectors needs to be applied to the circuit. Identifying a sequence of input test vectors that accomplishes these state transitions is not an easy task. Typically, designers who are intimately familiar with the circuit design methodically and painstakingly create these vectors. For example to test the behavior for a circuit relative to a certain bus, the sequence of input vectors is designed to bring the circuit under design to a particular state where, for example, access to that certain bus is requested. Thereafter, the test vectors may be designed to drive the system to a point where the requested bus access is granted, and the question that is resolved is whether, access to the requested bus is indeed granted.

Obviously, this approach is fraught with difficulty. The people who design, or choose, the test vectors must be very familiar with the design, mistakes are bound to happen, and consequently the whole design process is very time consuming.

### Summary

These difficulties are overcome by employing a conventional verification tool in a unique manner. Specifically, the conventional verification tool is employed in a process where the verification tools brings the system under test to a first state, receives directions to bring the system under test to a next state, brings the system under test to the next state, receives directions again, and so continues. To identify a set of input vectors that move the circuit form a first state to the second state in the desired sequence, the verification tool is directed to prove the hypothesis that the circuit cannot be brought to the second state. When the design is correct, the verification fails in its attempt to prove the hypothesis, and provides a set of input vectors that, as a counter example, brings the circuit to the second state. In disproving the hypothesis, the normal operation of the verification tool brings the circuit to the second state and provides, as a trace, the set of input vectors that disprove the hypothesis. The process continues from the arrived second state by directing the verification tool to prove the hypothesis that the circuit cannot be brought to a third state in the tested sequence. In a correctly designed circuit, the verification fails in its attempt to prove this hypothesis as well, places the circuit in the third state, and provides, as a trace, the set of input vectors that disprove the hypothesis. Of course, if the verification tools succeeds in proving any of the presented hypotheses, the designer knows that the state for which a hypothesis was proven cannot be reached.

### Brief Description of the Drawing

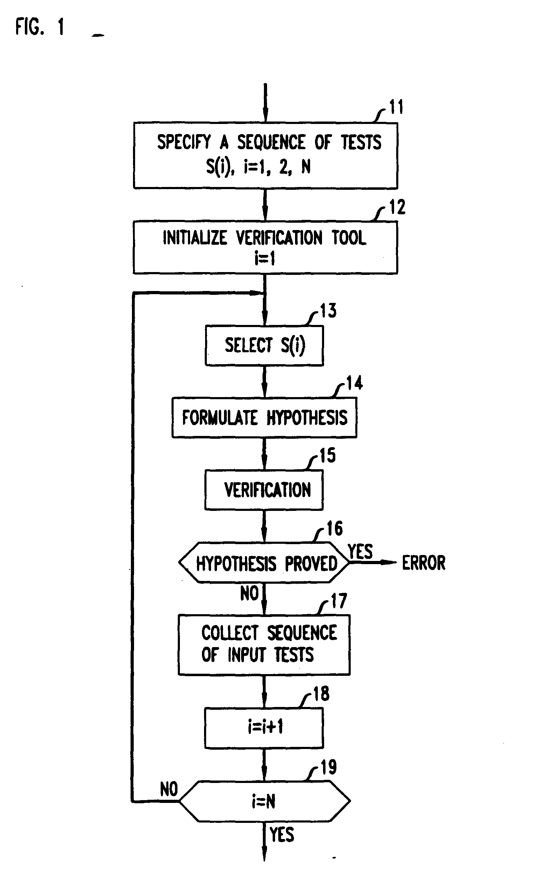

FIG. 1 presents a flow chart of a process employing the principles of this invention.

### Detailed Description

Software tools that formally verify a circuit design are well known in the art, and some are even available commercially. One such tool, known as COSPAN, is described in an article authored by Hardin, Z. Har'El, and R. P. Kurshan, "COSPAN," *Conference on Computer Aided Verification (CAV 96),* LNCS 1102, Springer-Verlag, (1996) pp. 423-427). Another description is found in U.S. Patent 5,163,016, issued on November 10, 1992. COSPAN is currently licensable by Lucent Technologies, and equipment that employs a verification tool that is based on COSPAN, called FormalCheck^{™}, can be licensed from Cadence Design Systems, Inc.

FormalCheck verifies a design through formal stepwise refinements of the design specification. An approach based on partial order reduction is disclosed in a copending application titled "Verifying Hardware in its Software Context and Vice-Versa," filed on 10/14/1998, and bears the Serial No. 09/172,484.

To overcome the difficulties of prior art approaches to developing test sequences, in accordance with the principles disclosed herein, a verification tool is employed within a process were the designer merely specifies the states that the designer wishes to test. As will become apparent below, the designer no longer needs to be familiar with the circuit's designs and no longer needs to painstakingly specify sequences of input test vectors that would move the circuit (if the circuit's design is proper) from one given state to another given state. Such verification is obtained, and a set of test vectors is realized for moving the circuit from one state to another state, by modifying a conventional verification engine to enable it to stop at an arrived state, to remember that state, and to be initialized to that state at a next iteration. When a verification tool is employed whose clock cannot be accessed, that entails providing memory for storing information for initializing the circuit to the arrived state. Otherwise, the clock is merely stopped when the verification tool reaches the arrived state, and that state serves as the starting state for the next iteration. To move the tested circuit to the next state, the verification tool is directed to prove a particular hypothesis. The hypothesis that the verification tool is asked to prove is that the circuit *cannot* reach the destination state from the starting state. When the circuit is designed correctly, this hypothesis cannot be proven and, in fact, the verification tool affirmatively disproves it by demonstrating that the opposite hypothesis is correct. To demonstrate the correctness of the opposite assertion, the tool provides an example of an input sequence that brings the circuit to the destination state. There may be other input sequences that lead to the destination state from the starting state, but one input sequence proves the assertion. The byproduct of this proof is the set of input sequences that the test process is seeking.

FIG. 1 presents a flowchart of a process in conformance with the principles disclosed herein. In block 12, the employed verification tool is initialized, and *i* is set to 1. Control then passes to block 13 where a first state S(*i*), *i*=1 that the circuit is asked to reach, is provided by the user. Block 14 formulates the hypothesis that the tested circuit cannot reach state S(1) from its initial state. The verification process of the tool is executed in block 15, and the result is evaluated in block 16. If the hypothesis is proven, the verification tool of block 15 effectively states "hypothesis proved", and block 16 outputs the error message. Otherwise, block 16 moves the circuit to the desired destination state of the hypothesis, as a means of disproving the hypothesis, and provides the sequence of input signal vectors that achieve this movement of the circuit. Decision block 16 recognizes this event as a rejection of the hypothesis, and passes the developed sequence to block 17. Block 17 collects the set of input vectors (associated with state *S*(*i*)) and passes control to block 18 where index *i* is incremented, and passes control to block 19. Block 19 invites the user to provide another input state to be tested. If such is provided, control returns to block 13. Otherwise, the process terminates.

The above description is couched in terms of a circuit design, but it should be understood that the developed test sequences could be employed to test manufactured circuits. It should be also understood that the principles disclosed herein apply to systems that comprise circuits and software, as well as to systems that consist of hardware alone or software alone. It should be understood further that various modifications, enhancements, and improvements could be added without departing from the scope of this invention.

For example, it is quite possible to direct the verification tool to provide not just *any* set of input vectors that brings the system from one state to another state but, rather, to provide the *smallest* set of input vectors that achieves this goal. It is also possible to put a ceiling on the number of test vectors in the set, by formulating a hypothesis that includes the condition; for example, "prove that the circuit/system cannot reach state S(j) in 25 steps or less." Other conditions can also be included in the hypothesis, such as whether the system will ask for a particular resource, enter a particular state, ask for a particular resource a certain number of times, refrain from entering a particular state, etc.

## Claims

1. A method for testing a system design comprising the steps of:
for said system at an initial state, specifying a destination state for said system is to traverse;
formulating a hypothesis that said system cannot reach said destination state;
executing a process for proving or disproving said hypothesis;
when said hypothesis is disproved, outputting a sequence of input test vectors that cause said system to traverse from said initial state to said destination state, placing said system in said destination state, thus making said destination state a new initial state of said system, and returning to said step of specifying; and
effecting an error termination of said method when said step of executing proves said hypothesis.

2. The method of claim **1** where said placing said system in said destination state to form said new initial state involved initializing said system to said new initial state.

3. The method of claim **1** where said placing said system in said destination state is effected by applying said sequence of input test vectors to said system.

4. The method of claim **1** where at each iteration of said step of specifying, said method receives a destination state from a user.

5. The method of claim **1** where at each iteration of said step of specifying, said method receives a destination state from a memory .

6. The method of claim **1** where said process that is executed in said step of executing is a process carried out in a verification tool.

7. The method of claim **6** where said verification tool is COSPAN.

8. The method of claim **1** where said system is a circuit.

9. The method of claim **1** where said system is a software system.

10. The method of claim **1** where said system includes both hardware and software.

11. The method of claim **1** where said hypothesis that said system cannot reach state *S*(*i*-1) to state *S*(*i*) is augmented with at least one other condition.

12. The method of claim **11** where said condition relates to a number of input signal vectors that need to be applied to said system to cause said system to traverse from state *S*(*i*-1) to state *S*(*i*).

13. The method of claim **12** where said condition specifies a maximum number of said input signal vectors that may be employed to traverse said system from state *S*(*i*-1) to state *S*(*i*).

14. The method of claim **11** where said condition relates to states that said system may enter in traversing said system from state *S*(*i*-1) to state *S*(*i*).

15. The method of claim **14** where said condition restricts said system, in traversing said system from state *S*(*i*-1) to state *S*(*i*), from entering a particular state more than a chosen number of times.

16. The method of claim **15** where said chosen number of times is 0.

17. The method of claim **14** where said condition restricts said system from entering a particular state in traversing said system from state *S*(*i*-1) to state *S*(*i*).

18. The method of claim **11** said condition relates states that said system may not enter in traversing said system from state *S*(*i*-1) to state *S*(*i*).

19. The method of claim **1** where said step of executing, when it disproves said hypothesis, outputs a set of input signal vectors that, if applied to said system, would cause said system to reach state *S*(*i*).

20. The method of claim **12** where said step of executing, when it disproves said hypothesis, outputs a set of input signal vectors that meets said condition and that, when the input signal vectors of said set are applied to said system in sequence, causes said system to reach state *S*(*i*).

21. A method for generating a set of test vectors comprising the steps of:
for said system at an initial state, specifying a destination state for said to traverse;
formulating a hypothesis that said system cannot reach said destination state;
executing a process for proving or disproving said hypothesis;
when said hypothesis is disproved, appending to said set of test vectors a sequence of input test vectors that cause said system to traverse from said initial state to said destination state, placing said system in said destination state, thus making said destination state a new initial state of said system, and returning to said step of specifying; and
effecting an error termination of said method when said step of executing proves said hypothesis.

22. The method of claim **21** further comprising a step of accumulating said set of test vectors in a memory.

23. A method for testing a system with a sequence of input test vectors and observing outputs of said system, to determine that a specified sequence of states is traversed, where said sequence of input test vectors is developed with a process comprising the steps of:
for said system at an initial state, specifying a destination state for said to traverse;
formulating a hypothesis that said system cannot reach said destination state;
executing a process for proving or disproving said hypothesis;
when said hypothesis is disproved, appending to said set of test vectors a sequence of input test vectors that cause said system to traverse from said initial state to said destination state, placing said system in said destination state, thus making said destination state a new initial state of said system, and returning to said step of specifying; and
effecting an error termination of said method when said step of executing proves said hypothesis.

24. A method for testing a system comprising the steps of:
specifying a sequence of states *S*(*i*) that the system is to traverse, where *i*=1, 2, ... *N*, and where *S*(0) is an initial state of the system;
for each of said state *S*(*i*), formulating a hypothesis that said system cannot enter state *S*(*i*) from state *S*(*i*-1);
executing a process for proving or disproving said hypothesis;
when said hypothesis is disproved and index *i* is less than *N*, incrementing index i, placing said system in state *S*(*i*), and returning to said step of selecting; and
effecting an error termination of said method when said step of executing proves said hypotheses.
